(19) Europäisches Patentamt
European Patent Office
Office européen des brevets

(11) **EP 3 995 842 B1**

(12) **EUROPEAN PATENT SPECIFICATION**

(45) Date of publication and mention of the grant of the patent:
**14.08.2024 Bulletin 2024/33**

(21) Application number: **20837163.3**

(22) Date of filing: **26.06.2020**

(51) International Patent Classification (IPC):
*G01R 29/10* (2006.01)

(52) Cooperative Patent Classification (CPC):
**G01R 29/10**

(86) International application number:
**PCT/ES2020/000031**

(87) International publication number:
**WO 2021/005250 (14.01.2021 Gazette 2021/02)**

(54) **SYSTEM AND METHOD FOR ANTENNA DIAGNOSIS**

SYSTEM UND VERFAHREN ZUR DIAGNOSE BEI ANTENNEN

SYSTEME ET PROCÉDÉ POUR LE DIAGNOSTIC D'ANTENNES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.07.2019 ES 201900105**

(43) Date of publication of application:
**11.05.2022 Bulletin 2022/19**

(73) Proprietor: **Universidad de Oviedo**
**33003 Oviedo (ES)**

(72) Inventors:
• **ÁLVAREZ NARCIANDI, Guillermo**
**33003 - Oviedo (Asturías) (ES)**
• **LAVIADA MARTÍNEZ, Jaime**
**33003 - Oviedo (Asturías) (ES)**
• **ÁLVAREZ LÓPEZ, Yuri**
**33003 - Oviedo (Asturías) (ES)**

• **LAS-HERAS ANDRÉS, Fernando**
**33003 - Oviedo (Asturías) (ES)**

(74) Representative: **Balder IP Law, S.L.**
**Paseo de la Castellana 93**
**5ª planta**
**28046 Madrid (ES)**

(56) References cited:
CN-A- 106 291 130     US-A1- 2017 089 968
US-A1- 2019 086 459     US-B1- 7 876 276

• HE HUI ET AL: "The Development of an EM-Field Probing System for Manual Near-Field Scanning", IEEE TRANSACTIONS ON ELECTROMAGNETIC COMPATIBILITY, IEEE SERVICE CENTER , NEW YORK , NY, US, vol. 58, no. 2, 1 April 2016 (2016-04-01), pages 356 - 363, XP011602093, ISSN: 0018-9375, [retrieved on 20160309], DOI: 10.1109/TEMC.2015.2496376

EP 3 995 842 B1

## Description

### TECHNICAL FIELD

The present invention relates a system and to a method for antenna diagnosis by means of the use of a handheld device. The system comprises a probe antenna which is moved manually by the operator of the system along an arbitrary path and captures the radiated signals radiated by the antenna being measured, a radiofrequency unit which measures the properties of said signal, positioning means providing the position of the probe antenna and processing means which perform diagnosis of the antenna being measured from the obtained data. The method of the invention comprises defining at least one reference surface close to the antenna being measured, moving the probe antenna along a path, homogenising the spatial sampling of the measurements, processing the information to obtain the representation of the electromagnetic field and diagnosing the antenna.

The invention is useful in industries where rapid antenna diagnosis is required, preventing the use of large sized measurement systems, such as in the communications industry. Furthermore, it is of particular interest in areas where antennas made up of many radiating elements are deployed, where the likelihood of failure of a component is not negligible. The invention allows the detection of abnormally behaving radiating elements, which is an important aspect to assure the proper operation of a system. This situation is common in advanced communication networks, such as in those networks that involve picocells deployed for 5G networks.

### BACKGROUND OF THE INVENTION

The diagnosis of antennas and electromagnetic emission radiating systems is a fundamental aspect to assure compliance with the specifications thereof. The progress made in telecommunication systems necessitates antennas with more demanding requirements, reducing margins and tolerances in the design. The radiofrequency technology of the new 5G communication systems, where to optimise coverage, telephony base stations equipped with smart antennas, that is, antennas capable of generating one or more beams providing coverage to users connected to said base station, are intended to be used, can be mentioned by way of example. Likewise, increasingly more satellite communication systems use techniques based on beam shaping and electron scanning, where the antennas incorporate electronic and radiofrequency circuits which allow the aiming of the beam of the antenna to be modified in real time (for example, antennas of communication equipment onboard moving vehicles which must be kept aimed at a satellite). This means that the technology for antenna diagnosis and characterisation capable of carrying out the measurement of these antennas under realistic operating conditions has become increasingly more important.

Generally speaking, systems for antenna diagnosis can be classified into outdoor systems or ranges, and indoor systems or ranges. Outdoor systems or ranges allow the direct measurement of the radiation pattern of the antenna intended to be diagnosed, given that it is possible to separate the antenna being measured from the antenna being used as a probe, such that far field measurements are taken. The main drawbacks they have are fundamentally the long distance needed between the infrastructure where the antenna being measured is placed and the probe antenna for being able to take the far field measurement. Furthermore, exposure to weather also conditions and limits their use.

Indoor systems or ranges are typically located in fixed enclosures referred to as anechoic chambers, which are entirely coated by a material that absorbs electromagnetic radiation to minimise the reflection of radio waves off the walls, floors and ceilings. Like in outdoor ranges, the antenna being measured is placed at a fixed base or tower with the capacity to describe rotations, and the antenna being used as a measurement probe is placed at another stationary base or tower a certain distance from the first one.

The electromagnetic field radiated by an antenna and/or radiating system can mainly be classified into two spatial regions: the near field region, where the spatial distribution of radiated energy changes with the distance to the antenna, and the far field region, where the spatial distribution of the radiated energy does not change with the distance to the antenna. Depending on the size of the antenna being measured, on the working frequency and on the separation between the antenna being measured and the measurement probe, the electromagnetic field radiated by the antenna being measured can be acquired in the near field or far field region. They are typically considered to meet the conditions Rmeasured $> 2D^2/\lambda$ and Rmeasured $> 10\lambda$ the electromagnetic field is measured in the far field region (where Rmeasured is the distance between the antenna being measured and the measurement probe, $D$ is the diameter of the minimum sphere circumscribed in the antenna being measured and $\lambda$ is the working wavelength).

The measurement of the radiation pattern of an antenna can only be taken in the far field. If the antenna is measured in the near field region, a near field to far field transformation method is needed to obtain the radiation pattern from the measurements taken, given that the spatial distribution of the radiated energy in the near field region changes with distance. The near field to far field transformation methods are based on the calculation of a set of coefficients which the electromagnetic field radiated by the antenna to be modelled, as described in the state of the art of patent document ES 2639687 (B2).

Antenna diagnosis in the near field region requires the measurement of both amplitude and phase of the electromagnetic field radiated by said antenna. To that end, measurement devices such as vector signal analysers or receivers with two channels (phase and quadrature) or the use of a method for recovering the phase of the electromagnetic field are needed.

Antenna and electromagnetic emission radiating system diagnosis comprises not only the characterisation of the radiation pattern but also the detection of failures and defects in the antenna, being of particular interest in the case of antenna clusters (or arrays), where the failure of a single element degrades the characteristics of the radiation pattern (for example, by worsening parameters such as directivity or side lobe ratio). It can also be useful for detecting deformations in reflector antennas. The detection of failures and defects in the antenna being measured is performed by means of the characterisation of the distribution of the radiated electromagnetic field at the closest possible distance to the surface thereof. It is possible to identify deformations or incorrectly operating elements from the representation of said field.

Systems currently used for measuring antennas, which allow retrieving information to perform the diagnosis thereof, have several drawbacks whether they are in the indoor range or in the outdoor range. In general, these systems are characterised by being highly complex, both in terms of construction and operation, restricting their implementation. On one hand, they require a specialised, complex infrastructure and massive facilities. On the other hand, personnel in charge of taking measurements must be specialised, trained and extremely knowledgeable in the subject matter. Furthermore, electromechanical elements are also needed for positioning the antenna being measured and the probe used in the measurement. Likewise, the configuration and precision of the positioning system is one of the determining factors that define the type of antennas that can be measured in a given antenna measurement system.

The development of positioning systems has allowed the introduction of systems based on robotic arms for antenna measurement such as the one described in patent US 20180368011 (A1) or in the paper by Gordon, J. A., Novotny, D. R., Francis, M. H., Wittmann, R. C., Butler, M. L., Curtin, A. E., & Guerrieri, J. R "Millimeter-Wave Near-Field Measurements Using Coordinated Robotics." IEEE Transactions on Antennas and Propagation, pp. 5351-5362, 2015, December. This document describes a system and method for antenna measurement using a positioning consisting of a robotic arm, which allows the measurement of the field radiated by the antenna being measured in different measurement ranges (plane, cylindrical, spherical). The system has a positioning precision of less than 22 $\mu$m. Given that antenna diagnosis requires the separation between two adjacent measurement points to be equal to or less than the mean wavelength at the measurement frequency when a detector capable of measuring amplitude and phase is used, and equal to or less than a quarter wavelength at the measurement frequency when a detector capable of measuring only amplitude is used, the described system allows antennas to be measured up to a frequency of 300 GHz. The main limitation of systems that use this type of positioner is the high complexity and cost of a robotic arm, which furthermore requires being handled by a skilled operator.

In the case of large antenna diagnosis, different solutions have been proposed. Patent document ES 2639687 (B2) discloses an airborne system and method for the characterization and measurement of antennas or radiating systems, formed by at least one aerial module, one ground-based station and a communication system between elements. The invention also relates to the method of processing the electromagnetic field radiated in order to obtain both the radiation pattern and the field in the aperture of the antenna for failure detection purposes. This system is conceived for *in situ,* outdoor measurements of antennas under operating conditions (such that the radio communication service does not need to be interrupted for antenna diagnosis) in hard-to-access locations which make the use of airborne systems appropriate. The main limitations of this system and methods are, on one hand, the maximum positioning and georeferencing accuracy of the measurements, specified at 3 cm, which imposes an upper limit in frequency of the antennas that can be diagnosed (indicating about 5 GHz). Moreover, the use of an airborne system increases the complexity of the system and the specialisation of system operators, being comparable to one having an antenna measurement range with mechanical moving parts.

The paper by A. Geise, O. Neitz, J. Migl, H.-J. Steiner, T. Fritzel, C. Hunscher, T. F. Eibert, "A Crane Based Portable Antenna Measurement System - System Description and Validation", IEEE Transactions on Antennas and Propagation, pp. 1-12, 2019, describes a system and method for antenna measurement where the probe used for the radiated field measurement, as well as the radiofrequency equipment, are onboard a nacelle hanging from a bridge crane which is moved above the antenna or radiating system being measured. The proposed system involves the acquisition of the radiated field on measurement surfaces that are irregular due to the nature of the movements described by the nacelle. The system has various limitations, such as the need for a large infrastructure that supports the nacelle. Likewise, the handling of the system is complex, since the design of the path and the orientation of the probe antenna requires taking into account all the inertias of the nacelle, weight, frictions or accelerations, among other aspects of the dynamics thereof, as the authors mention in the paper in which they have presented the system.

Patent document US 20180351631 (A1) discloses a movable device formed by at least one pair of antennas, a horizontal polarisation antenna and another vertical polarisation antenna. The device also includes a position detecting system, an electromagnetic field intensity detector and an information processing unit. The device allows the position of each measurement to be obtained, providing intensity maps of the signals radiated by the device being measured, for example a WiFi emitter. Said patent document claims the capacity to obtain specific parameters of radiated signals, such as phase measurement and delay spread. However, the system is limited to generating intensity maps of the captured signals or to measuring certain parameters thereof without actually obtaining the radiation pattern or the diagnosis of the element emitting same.

The paper by H. He, P. Maheshwari, and D. J. Pommerenke, "The development of an EM-field probing system for manual near-field scanning. ", IEEE Transactions on Electromagnetic Compatibility, 58, 356-363, April 2016, discloses a system and method for the diagnosis of circuits electronic by means of the measurement of the electric and magnetic field radiated by the electronic components forming said circuits. The system is formed by an optical positioning system which allows the position of the measurement probe of the electric and magnetic field at each measurement point to be obtained. Said measurement probe is connected to a spectrum analyser which allows the intensity of the electric and magnetic field to be acquired, allowing the viewing thereof in real time. However, the measurements obtained with the probe are not obtained with suitable sampling or processed to determine the source of said radiation, but rather are simply represented by creating electromagnetic emission intensity maps. This impedes, for example, field modelling with simple elements such as basis functions in terms of which it is possible to express the fields in the aperture or radiation modes (e.g., spherical, plane or cylindrical wave expansion) which allow more precise representations of the operation of the radiating system to be obtained, which impedes greater precision in antenna diagnosis. For example, if the antenna is protected by a radome, this system would not allow fields inside said radome to be obtained.

Patent document US 20180090837 (A1) discloses a system and method for characterising the operation of active phased array antennas and the behaviour thereof with respect to temperature changes. To that end, said patent document combines near field measurements radiated by the antenna being measured using an XYZ measurement range, which uses an articulated robotic arm with thermal images captured by a thermal camera. The document claims the possibility of characterising the amplitude and phase of each of the elements forming the phased array antenna. Canonical acquisition domains are used in this system. However, the system requires the use of a complex infrastructure characterised by the use of an articulated robot. It is also a large sized, fixed system and is not indicated for characterising or diagnosing antennas once they are deployed.

Patent document US 9439092 (B1) discloses a system and method to carry out mobile telephony antenna diagnosis. This invention uses heat maps to determine the elements or antennas having an abnormal operation, given that the thermal image of the antennas is proportional to the emission power thereof. The main drawback of this invention is that it is only useful in antennas that irradiate enough heat. Furthermore, it does not allow the amplitude or phase of the field in the aperture to be obtained, so it does not allow suitable diagnosis of antenna clusters. Furthermore, it does not allow the measurement of the radiation pattern either, i.e., it does not allow an evaluation of the consequences of the abnormal operation of a radiating element, which could radiate acceptably within the necessary specifications without the repair or replacement thereof being necessary.

## DESCRIPTION OF THE INVENTION

The present invention relates to a system for antenna diagnosis by means of measurements taken by moving one hand and without mechanical restrictions, at least one probe antenna opposite the antenna being measured, acquiring the radiated signal at a set of arbitrary of points. The system also includes positioning means capable of determining the position of the probe antenna used to capture the radiated signal radiated by the antenna being measured. The data acquired from the radiated signal, as well as the position where those acquisitions have been performed, are processed by processing means which calculate information about the distribution of the electromagnetic fields in the aperture of the antenna being measured. It is thereby possible to evaluate whether the amplitudes and phases in the aperture, as well as the characteristics of the far field are correct.

The invention also relates to a method for antenna diagnosis using the preceding system which comprises processing the measured values to obtain the field data in the aperture and the radiation pattern of the antenna being measured.

For purposes of this invention and the description thereof, antenna being measured refers to the antenna that is analysed and diagnosed to find possible operating abnormalities.

One object of the present invention therefore relates to a system for antenna diagnosis comprising:

- At least one probe antenna, which can be arbitrarily moved by hand by the person operating the system, capturing the radiated signal radiated by the antenna being measured when it moves along a path. The probe antenna captures at least one component of the electric field at the point where it is situated.
- A radiofrequency (RF) unit that measures one or more of the properties of the signal captured by the probe antenna along a path.

For purposes of this invention and the description thereof, the properties of the measured or captured signal refer to either the intensity and phase, or else to only the intensity if only one property of the signal captured by the probe antenna is measured.

- Positioning means providing the position of the probe antenna along the path.
- Processing means with at least one processor, one memory and one programme or programmes which are stored in the memory and comprise a plurality of instructions. The processing means perform diagnosis of the antenna being measured, by processing the properties of the signal measured by the radiofrequency unit combined with the position of the probe antenna provided by the positioning means.

The probe antenna of the system can be moved manually by an operator following an arbitrary path, within an investigation volume. The investigation volume comprises a reference surface which is situated at a distance comprised between 1 cm and 100 cm from the antenna being measured.

For purposes of this invention and the description thereof, a virtual surface close to which the probe antenna that captures the radiated signal radiated by the antenna being measured is moved is referred to as a reference surface.

Moreover, the processing means of the system comprise a plurality of instructions which, when executed by the processor, diagnose the antenna being measured. This diagnosis is performed by means of the calculation of at least the tangential component of the electric field, or of the magnetic field, or of both, in the aperture of the antenna being measured based on a representation by means of a basis function expansion of equivalent currents in the aperture or electric field modes obtained from the properties of the signal captured by the probe antenna associated with the position provided by the positioning means.

In a preferred embodiment of the system, said system comprises two probe antennas with orthogonal polarisations that allow the measurement of the radiated signal radiated by the antenna being measured for two separate polarisations. An example system with the capacity to measure two separate polarisations would be one comprising two antennas with orthogonal linear polarisations and an RF unit made up of two power detectors, each of which is connected to a different antenna.

In another preferred embodiment, the radiofrequency unit measures both the phase and the intensity of the signal captured by the probe antenna. In a more preferred embodiment, the radiofrequency unit comprises a handheld vector network analyser.

An example RF unit capable of providing the intensity and phase would be a vector network analyser having at least two ports, with a wireless or wired interface that transmits the measurements taken, together with an antenna operating like an electromagnetic field probe. In this embodiment, one of the ports of the vector network analyser would be connected to the probe, which could be moved by hand, and the other one would be connected to the antenna being measured.

In another preferred embodiment of the system, the RF unit provides the intensity of the signal captured by the probe antenna. In a more preferred embodiment, the radiofrequency unit comprises a power detector. In another preferred embodiment, the radiofrequency unit comprises a spectrum analyser.

An example RF unit providing intensity would be a power detector connected to an antenna through an RF port and the video output of which is connected to an analog-to-digital converter which sends its data to the processing system through a wireless or wired interface such as a serial port or USB. In this example, the RF unit would be made up of the power detector and the analog-to-digital converter together with the connection interface. Another example RF unit providing the intensity of the radiated signal is a spectrum analyser with an interface, such as a GPIB port, which transmits the obtained data and is connected to the probe antenna or antennas by means of flexible radiofrequency cables.

In another preferred embodiment of the system, the RF unit is capable of extracting the information from the acquired radiated signal, allowing the parameters thereof to be detected. An example of the extraction of information from the radiated signal would be a system for 5G antenna diagnosis capable of detecting and interpreting the Synchronisation Signal Blocks (SSB) and of measuring the intensity corresponding to each SSB, allowing an intensity to be assigned to each beam radiated by the antenna being measured.

In another preferred embodiment, the positioning means are an optical tracking system of the probe antenna along the path.

In a more preferred embodiment, the optical tracking system comprises at least one infrared camera, or at least one visible spectrum camera, or at least one depth camera, or a combination of the foregoing. Even more preferably, the optical tracking system captures the movement of the probe antenna or antennas by means of markers attached to the probe antenna or antennas, while the cameras are placed in fixed positions.

In another more preferred embodiment, the optical tracking system comprises an integrated camera in the probe antenna that captures successive images along the path. In one example, the captured images can be processed by means of photogrammetry. In another example, the integrated camera can be a depth camera that measures point clouds continuously, such that the position of the probe antenna can be obtained by comparing the differences between point clouds.

In another preferred embodiment, the positioning means comprise an ultrawideband (UWB) positioning system estimating the position of the probe antenna along the path.

In another preferred embodiment, the positioning means comprise an inertial sensor arranged in the probe antenna providing relative data about its position along the path. Thus, for example, an inertial sensor can be materialised by means of an inertial measurement unit (IMU) equipped with accelerometers and gyroscopes.

In a more preferred embodiment, the positioning means provide the position of the probe antenna from the data from the inertial sensor combined with the images captured by the integrated camera. For example, the positioning means can integrate a depth camera and an IMU. In this example, the position would be provided by applying the iterative closest point (ICP) algorithm, using the point clouds measured by the depth camera and the tilt detected by the IMU as input.

In another preferred embodiment, the probe antenna and the RF unit are integrated in a single device. In a more preferred embodiment, the positioning means are integrated in one and the same device together with the probe antenna and the radiofrequency unit.

In an even more preferred embodiment, that device is a mobile telephone. Thus, for example, the probe antennas of the system are the antennas of a mobile telephone; the RF unit is the communication system of said mobile telephone, which measures the properties of the radiated signal radiated by the antenna being measured; the processing means are the processing unit of the mobile telephone; and the positioning means are formed by the sensors of the mobile telephone and its processing unit.

In another preferred embodiment, the processing means comprise a plurality of instructions which, when executed by the processor, cause the processing means to be configured to execute the method for antenna diagnosis of the invention.

In another preferred embodiment of any of the preceding embodiments, the data processing subsystem also calculates the far field radiation pattern of the antenna being measured.

Another object of the present invention relates to a method for antenna diagnosis by means of the preceding system from data about the radiated signal radiated by said antennas. The method comprises the following steps:

a) Defining at least one reference surface based on the properties of the radiated signal radiated by an antenna being measured which the radiofrequency unit is capable of measuring. The reference surface is situated at a distance comprised between 1 cm and 100 cm from the antenna being measured.

b) Manually moving a probe antenna describing an arbitrary path within an investigation volume. The investigation volume comprises the reference surface. As the probe antenna moves, it captures the radiated signal radiated by the antenna being measured and its properties are measured by means of a radiofrequency unit. The position of the probe antenna along the path is also determined.

c) Homogenising the spatial sampling of measurements of the radiated signal radiated by the antenna being measured.

For purposes of this invention and the description thereof, homogenising the spatial sampling refers to establishing a method that regulates data acquisition at arbitrary positions such that a dataset with a more balanced distribution is obtained, selecting a maximum data number per unit of volume that is within a pre-established range.

d) Processing the acquired information to obtain a representation of the electromagnetic field generated by the antenna being measured as a basis function expansion.

e) Diagnosing the antenna being measured by means of the calculation of at least the tangential component of the electric field, or of the magnetic field, or of both, in the aperture of the antenna being measured. It is thereby possible to identify defective radiating elements.

In a preferred embodiment of the method, the properties measured in step b) are both the phase and the intensity of the signal captured by the probe antenna and a single reference surface is defined.

In a more preferred embodiment, the coefficients of the basis function expansion of the electromagnetic field of step d) when measuring both phase and intensity are obtained by finding the coefficients that minimise the cost function

$$CF(x) = \|Ax - b\|_2$$

where CF is the cost function, b is a column vector with the field measurements, *x* is a vector with the coefficients of the fundamental elements and A is a matrix containing the linear relationship between the basis functions and the field measurements. An example would be the use of the sources reconstruction method (SRM), which allows the representation of the radiated electromagnetic field by means of equivalent currents.

In another preferred embodiment of the method, the property measured in step b) is the intensity of the signal captured by the probe antenna. In a more preferred embodiment, two reference surfaces are defined in step a). In an even more preferred embodiment, the representation of the electromagnetic field generated from the basis function expansion of step d) comprises the following sub-steps:

d.i) Assigning an arbitrary initial phase $\varphi_1$ to the data measured in the first reference surface.
d.ii) Calculating the weights of basis functions as coefficients that minimise the cost function

$$CF_1(x) = \|A_1 x - b_1\|_2$$

where $CF_1$ is the cost function, $b_1$ is a column vector with the field measurements in the first surface with the measured intensity and with phase $\varphi_1$, x is a vector with the weights of the basis functions and $A_1$ is a matrix containing the linear relationship between the basis functions and the field measurements in the first of the surfaces.
d.iii) Calculating the field in the second reference surface from the basis function expansion calculated in step d.ii) obtaining a phase vector $\varphi_2$ corresponding to the field in the measured positions of the second reference surface.
d.iv) Calculating the coefficients of the basis functions, which will be those that minimise the cost function

$$CF_2(x) = \|A_2 x - b_2\|_2$$

where $CF_2$ is the cost function, $b_2$ is a column vector with the field measurements in the second surface with the amplitude measured and with the phase calculated in step d.iii), $\varphi_2$, x is a vector with the weights of the basis functions and $A_2$ is a matrix containing the linear relationship between the basis functions and the field measurements in the first of the surfaces.
d.v) Calculating the field in the first reference surface from the basis function expansion calculated in step d.iv) obtaining a phase vector $\varphi_1$, corresponding to the field in the measured positions of the first reference surface.
d.vi) Repeating steps d.ii) to d.v) if at least one convergence criterion is not achieved. Otherwise, this algorithm is stopped.

An example convergence criterion for step d.vi) is for the number of iterations to exceed an established value. Another example convergence criterion is for the error to be below a threshold determined by:

$$e(x) = (1 - a)\|A_1 x - b_1\|_2 + a\|A_2 x - b_2\|_2$$

where $a$ is a parameter which balances out the weight between the error in surface one and surface two. An example would be the use of the phaseless source reconstruction method (pSRM) which allows the representation of the intensity of radiated electromagnetic field by means of equivalent currents, expressed by means of a basis function expansion.

In another preferred embodiment of the method, the homogenisation of step c) comprises discretising the investigation volume from the orthogonal projection at a distance h from cells comprised in the reference surface or surfaces. A plurality of non-overlapping discrete volumes is thereby configured, wherein the number of captures of the radiated signal does not exceed a certain threshold. When the number of measurements exceeds the threshold, they are discarded. For example, it may be possible to retain only two measurements of the radiated signal radiated by the antenna being measured per each discrete volume, such that there are no cells with a significantly higher number of measurements than other cells.

In a more preferred embodiment, the reference surface is planar and the discrete volumes are right prisms or cuboids.

In another specific embodiment of the method, after step e), the method further comprises step

f) Calculating the radiation pattern of the antenna being measured from the basis function expansion obtained in step d).

This new step in which the far field is calculated from the basis function expansion using near to far field transformation techniques is added after step e).

In another preferred embodiment of the method, the basis functions of the expansion of the electromagnetic field model electric and magnetic currents expressed as linear combinations of said basis functions.

In another preferred embodiment of the method, the basis functions of the expansion of the electromagnetic field are electromagnetic field modes. An example would be plane, cylindrical or spherical wave expansions.

In a specific embodiment of the previous embodiment, the modes are plane waves.

In another specific embodiment of the method, steps c), d) and e) are repeated for each of the beams radiated by the antenna being measured. For example, an antenna being measured with several beams would be an antenna of a base station of a 5G system emitting several beams. These beams can be identified and differentiated, and their intensity is measured such that a different basis function expansion for each beam is obtained.

In another preferred embodiment of the method of any of the previous embodiments, step e) for calculating the field in the aperture is implemented, calculating the radiated field from the basis function expansion. An example calculation of the field in the aperture in the event that the basis functions are plane waves would be a back propagation using plane to plane propagations. Another example calculation of the field in the aperture in the event that the basis functions are equivalent currents in the aperture would be to use the actual equivalent currents in the aperture as these already represent the tangential field in the aperture.

The invention provides, with respect to other systems that are known today, a system for antenna diagnosis which prevents the use of mechanical positioning elements or of large auxiliary structures, as a result of the use of a probe antenna which can be manually operated and positioning means which track the free movement of the probe antenna.

The invention also provides a method which allows the sampled data to be homogenised, thus achieving greater flexibility, portability and rapid deployment of the system. Furthermore, the system and method prevent the need for a skilled operator since they allow the operator of the system to perform data acquisition without the need to previously define the path to be followed and move the probe antenna with a certain tolerance.

The system likewise provides real-time visual feedback of the samples obtained allowing the operator to know in which areas the sampling must increase. Compared to other inventions which do allow arbitrary movements, the present invention provides the capacity to handle this arbitrary data and turn it into information relating to the field in the aperture, as a result of a correct spacing of the data, thus allowing to know the amplitude and phase of the field radiated by the different elements of the antenna, even in those cases where there is no physical access to the aperture, such as when the antenna is protected by a radome.

The present invention is useful in industries where rapid antenna diagnosis is required, preventing the use of large sized measurement systems, such as in the communications industry. Furthermore, it is particularly relevant in fields where many antennas made up of many radiating elements are deployed given that the likelihood of an element in the transmission chain, such as phase shifters or attenuators for modelling the beam, failing is not negligible. An example of this latter scenario is the deployment of picocells working in a millimetric band for 5G communications.

## BRIEF DESCRIPTION OF THE DRAWINGS

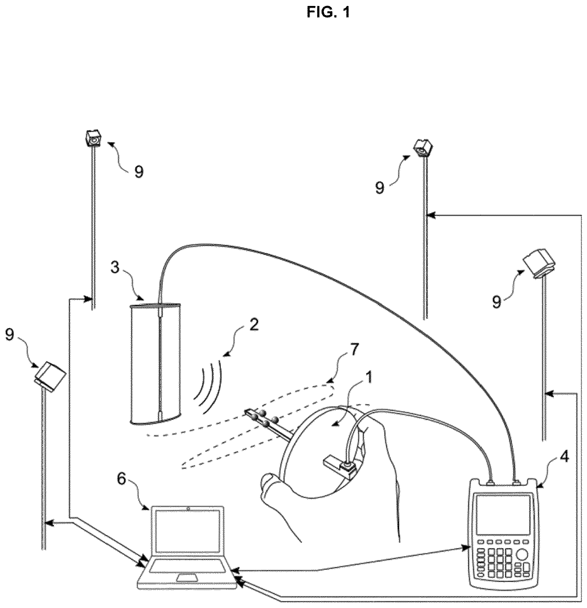

**Figure 1** shows an embodiment of the system corresponding to the system described in Example 1. The figure shows the probe antenna (1), which is moved by the operator of the system with one hand relative to the antenna being measured (3) describing an arbitrary path (7), connected to a radiofrequency unit (4) materialised in a handheld vector network analyser (13). The antenna being measured (3) is connected to the other port of said handheld vector network analyser (13) such that it is possible to obtain both the amplitude and the phase of the radiated signal (2) radiated by the antenna being measured (3) at different acquisition positions along the path (7). The positions of the probe antenna (1) in the which measurements of the electric field radiated by the antenna being measured (3) are taken are obtained by positioning means (5) materialised by means of an optical tracking system (8) formed by four infrared cameras (9) connected to processing means (6) represented by means of a computer which processes and controls data acquisition. The x-y-z coordinates and the tilt of the probe antenna (1) of the system are estimated by the optical tracking system (8) from the four markers (18) fixed to the probe antenna (1).

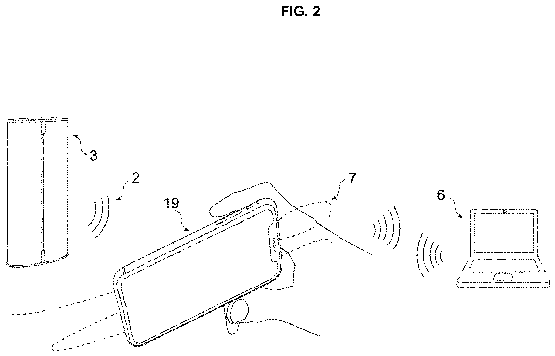

**Figure 2** shows an embodiment of the system corresponding to the system described in Example 3. In this case, the radiofrequency unit (4), the probe antenna (1) and the positioning means (5) are integrated in a 5G smartphone mobile telephone, which is moved describing an arbitrary path (7) relative to the antenna being measured (3). The radiofrequency unit (4) is formed by the communication system of the smartphone; the probe antennas (1) of the measurement system, in charge of acquiring the intensity of the radiated signal (2) radiated by the antenna being measured (3), are those pertaining to the smartphone; and the positioning means (5) are formed by the inertial sensors (10) and the depth camera (12) of the same telephone. The acquired data is sent through a WiFi connection to a computer which forms the processing means (6) and performs the diagnosis of the antenna being measured (3).

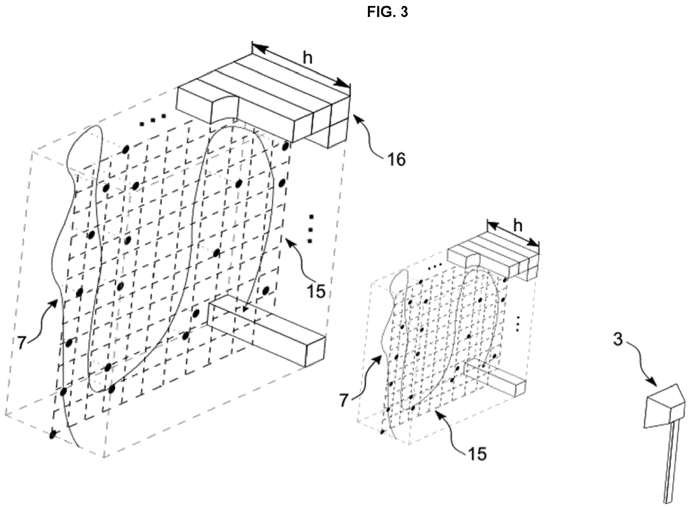

**Figure 3** depicts two reference surfaces (15) defined to characterise an antenna being measured (3) using only information about the intensity of the radiated signal (2) radiated by same. The two reference surfaces (15) are defined relative to the antenna being measured (3). For the homogenisation of the spatial sampling of the measured data, both reference surfaces (15) are segmented into cells which are projected forming a plurality of three-dimensional discrete volumes (16) in the form of non-overlapping right prisms, in which the number of field intensity acquisitions is limited. In this case, the projection of the field intensity acquisition positions on each reference surface (15) is represented with a black circle. In addition to spatial homogenisation, these discrete volumes (16) allow samples that are too far away from the reference surfaces (15) beyond a certain tolerance determined by the height h of the right prisms to be ruled out. The arbitrary path (7) described by the probe antenna (1) is represented by means of a solid line ending in an arrowhead in each reference surface (15).

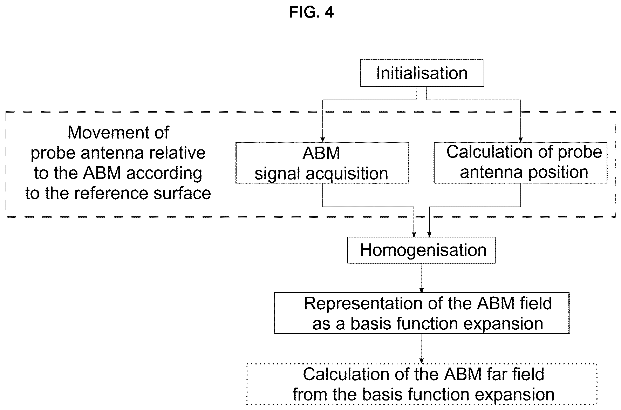

**Figure 4** shows the basic flow chart of the method for antenna diagnosis with the system described in this invention. First, system initialisation is performed, comprising the definition of the reference surface or surfaces (15), as well as the segmentation thereof into discrete volumes (16) which allow the spatial homogenisation of the acquired information. The probe antenna (1) is then manually moved relative to the antenna being measured (3) describing an arbitrary path (7) according to the previously defined reference surfaces (15). During said movement, acquisitions of the radiated signal (2) radiated by the antenna being measured (3) (either intensity and phase or only intensity, depending on the capacities of the radiofrequency unit (4)) are performed, and the position of the probe antenna (1) in which said acquisitions have been performed is calculated as a result of the information provided by the positioning means (5). Likewise, the spatial sampling of the field of the antenna being measured (3) is homogenised during acquisition, discarding those measurements acquired in positions that are outside the previously defined discrete volumes (16) or acquired within a discrete volume (16) in which the maximum number of acquisitions has been achieved. Lastly, the field of the antenna being measured (3) is characterised through its basis function expansion calculated from the available measurements. In a preferred embodiment of the method, said characterisation is updated as new measurements are obtained. The far field radiated by the antenna being measured (3) can optionally be calculated and the field thereof is modelled from the basis function expansion.

## PREFERRED EMBODIMENT OF THE INVENTION

To better understand the present invention, the following preferred embodiments, described in detail, are set forth without limiting the scope of the invention.

### EXAMPLE 1

A system was materialised formed by an RF unit (4) consisting of a handheld vector network analyser (13) connected through a port and a coaxial cable to an electric field probe antenna (1) consisting of a WR28 open-ended waveguide antenna operating in the range of 26.5 to 40 GHz (Ka band) that captures the radiated signal (2) radiated by the antenna being measured (3). The other port of the handheld vector network analyser (13) is used to inject the RF signal into the antenna being measured (3). This radiofrequency unit (4) was capable of providing the amplitude and phase of the electric field in a polarisation by means of the measurement of parameter S21. The connection of this subsystem was performed by means of a LAN interface which allowed SCPI (Standard Commands for Programmable Instruments) commands to be sent and received.

The positioning means (5) were materialised as an optical tracking system (8), formed by 4 infrared cameras (9) connected by means of a switch to a computer which tracked 4 markers (18) attached to the electric field probe antenna (1). The software processing provided the position in x-y-z coordinates as well as the tilt of the antenna by means of tilt angles (pitch, roll and yaw) along the path (7).

The processing means (6) were materialised as the same personal computer which processed the positioning data and communicated with the handheld vector network analyser (13) by means of SCPI commands.

### EXAMPLE 2

The system described in Example 1 was used to carry out the method for antenna diagnosis. The method was applied by means of performing the following steps:

a) A single reference surface (15) was defined, consisting of a plane having a size of 15 cm x 15 cm and situated parallel at 5 cm from the aperture of the antenna being measured (3), since the radiofrequency unit was capable of measuring the amplitude and the phase of the radiated signal (2) radiated by the antenna being measured (3).
b) The operator continuously moved the electric field probe antenna (1) with one hand, describing an arbitrary path (7), using the surface from step a) as a reference surface (15), capturing the radiated signal (2) radiated by the antenna being measured (3), measuring the amplitude and phase thereof, and determining the position of the probe antenna (1).
c) The spatial sampling was homogenised by retaining the first two electromagnetic field measurements acquired within each discrete volume (16).
d) The acquired information was processed to obtain a representation of the electromagnetic field generated by the antenna being measured (3) in terms of the magnetic currents, approximated by a linear combination of non-overlapping pulse basis functions, in an aperture having a size of 5 cm x 5 cm by means of the following operation:

$$x = A^\dagger b$$

where *b* is a column vector with the field measurements, *x* is a vector with coefficients of the magnetic currents and $A^\dagger$ the pseudo-inverse of the matrix A having an element in the *m*-th row and *n*-th column which contains the field radiated by the *n*-th basis function in the *m*-th point where the field has been measured.
e) The antenna being measured (3) was diagnosed by means of the calculation of the magnetic field in the aperture directly from the magnetic currents as they are proportional to the tangential magnetic field.

Steps b) to e) were repeated continuously, allowing the viewing of the currents in the aperture as the operator moved the probe antenna (1).
The reference surface (15) was divided into discrete volumes (16) formed by non-overlapping right prisms having a size of 3.5 mm x 3.5 mm x 3.5 mm, with two of their faces parallel to the reference surface (15).

EXAMPLE 3

This example is aimed at active 5G antenna diagnosis in the 28 GHz band. In this example, the radiofrequency unit (4) of the system was materialised in the communication system of a 5G smartphone with the capacity to detect the intensity of the different 5G beams emitted by the antenna being measured (3) identified by the SSB blocks. The probe antennas (1) that acquired the radiated signal (2) were those pertaining to the mobile telephone. The measured data is sent to a personal computer through a WiFi connection together with a timestamp.
The positioning means (5) were materialised as a depth camera (12) and an IMU (10), both belonging to the smartphone. The tilt data was obtained directly from the IMU (10). The position was obtained by calculating the relative x-y-z movement between point clouds acquired by the depth camera (12), corrected by the tilt of the telephone coming from the IMU (10) and processed by the Iterative Closest Point (ICP) algorithm. This data was processed in the CPU/GPU system of the smartphone and sent to a personal computer through a WiFi connection together with a timestamp.
The processing means (6) were materialised as a personal computer that received data about the intensity of each beam emitted by the antenna being measured (3) and about the positions of the probe antenna (1) provided by the positioning means (5).

EXAMPLE 4

The system described in Example 3 was used to carry out the method for antenna diagnosis. The method was applied by means of the following steps:

a) Two reference surfaces (15) were defined, consisting of two planes having a size of 30 cm x 30 cm, situated at 5 cm and 15 cm, respectively, from the aperture of the antenna being measured (3), since the radiofrequency unit was only capable of measuring the intensity of the radiated signal (2) radiated by the antenna being measured (3).
b) The operator continuously moved the electric field probe antenna (1) with one hand describing an arbitrary path (7) using the surfaces from step a) as reference surfaces (15).
c) The spatial sampling was homogenised by retaining the first two electromagnetic field measurements acquired within each discrete volume (16).
d) A basis function expansion consisting of plane waves was calculated following steps d.i) to d.vi) described in the embodiments of the method for each measured beam.
e) The tangential field in the aperture was calculated from the plane-wave expansion.
f) The radiation pattern of the antenna being measured (3) was calculated for each measured beam from the visible plane wave spectrum, with the following expression:

$$\vec{E}_{FF}(r, \theta, \phi) = jk \sin\theta \cos\phi \, \frac{e^{-jkr}}{r} \, \vec{T}(k_x, k_y)$$

where r, $\theta$ y $\phi$ is the spherical coordinates, k is the wave number and $\vec{T}(k_x, k_y)$ is the plane wave spectrum.

Steps from b) to f) were repeated continuously allowing the viewing of the currents in the aperture and the far field as the operator moved the probe antenna (1).

The reference surfaces (15) were divided into discrete volumes (16) formed by non-overlapping right prisms having a size of 5 mm x 5 mm x 5 mm, with two of their faces parallel to the reference surfaces (15).

**Claims**

1. A system for antenna diagnosis, comprising:

   - at least one probe antenna (1) that captures the radiated signal (2) radiated by the antenna being measured (3) when it moves along a path (7);
   - a radiofrequency unit (4) that measures one or more of the properties of the signal captured by the probe antenna (1) along a path (7);
   - positioning means (5) providing the position of the probe antenna (1) along the path (7);
   - processing means (6) with at least one processor, a memory and a programme or programmes which are stored in the memory and comprise a plurality of instructions performing the diagnosis of the antenna being measured (3) by processing the properties of the signal measured by the radiofrequency unit (4) combined with the position provided by the positioning means (5);

   **characterised in that** the probe antenna (1) can be moved manually by an operator following an arbitrary path (7) within an investigation volume, comprising a reference surface (15) which is situated at a distance comprised between 1 cm and 100 cm of the antenna being measured (3), and **in that** the processing means (6) comprise a plurality of instructions which, when executed by the processor, diagnose the antenna being measured (3) by means of the calculation of at least the tangential component of the electric field, or of the magnetic field, or of both, in the aperture of the antenna being measured (3) based on a representation by means of a basis function expansion of equivalent currents in the aperture or electric field modes obtained from the properties of the signal captured by the probe antenna (1) associated with the position provided by the positioning means (5).

2. The system according to claim 1, **characterised in that** the radiofrequency unit (4) measures the intensity of the signal captured by the probe antenna (1) or both the phase and the intensity of the signal captured by the probe antenna (1).

3. The system according to claim 2, **characterised in that**, when the radiofrequency unit (4) measures both the phase and the intensity of the signal captured by the probe antenna (1), the radiofrequency unit (4) comprises a handheld vector network analyser (13).

4. The system according to claim 2, **characterised in that**, when the radiofrequency unit (4) measures the intensity of the signal captured by the probe antenna (1), the radiofrequency unit (4) comprises a power detector (14) or a spectrum analyser.

5. The system according to claim 1, **characterised in that** the probe antenna (1) is integrated in the radiofrequency unit (4).

6. The system according to claim 5, **characterised in that** the positioning means (5) and the processing means (6) are integrated in one and the same device together with the probe antenna (1) and the radiofrequency unit (4), wherein the device is preferably a mobile telephone (19).

7. The system according to claim 1, **characterised in that** the processing means (6) comprise a plurality of instructions which, when executed by the processor, cause the processing means (6) to be configured to execute the method according to any of claims 8 to 15.

8. A method for antenna diagnosis by means of the system of claim 1, comprising the following steps:

   a) defining at least one reference surface (15) based on the properties of the radiated signal (2) radiated by an antenna being measured (3), wherein the reference surface (15) is situated at a distance comprised between 1 cm and 100 cm of the antenna being measured (3);
   b) manually moving a probe antenna (1) describing an arbitrary path (7) within an investigation volume comprising the reference surface (15), capturing the radiated signal (2) radiated by the antenna being measured (3) and measuring its properties by means of a radiofrequency unit (4), and determining the position of the probe antenna (1) along the path (7);

c) homogenising the spatial sampling of measurements of the radiated signal (2) radiated by the antenna being measured (3);

d) processing the acquired information to obtain a representation of the electromagnetic field generated by the antenna being measured (3) as a basis function expansion;

e) diagnosing the antenna being measured (3) by means of the calculation of at least the tangential component of the electric field, or of the magnetic field, or of both in the aperture of the antenna being measured (3);

wherein steps c), d) and e) are optionally repeated for each of the beams radiated by the antenna being measured (3).

9. The method according to claim 8, **characterised in that** the properties measured in step b) are both the phase and the intensity of the signal captured by the probe antenna (1), or the intensity of the signal captured by the probe antenna (1).

10. The method according to claim 9, **characterised in that**, when the properties measured in step b) are both the phase and the intensity of the signal captured by the probe antenna (1), the coefficients of the basis function expansion of the electromagnetic field of step d) are obtained by finding the coefficients that minimise the cost function

$$CF(x) = \|Ax - b\|_2$$

where $CF$ is the cost function, $b$ is a column vector with the field measurements, x is a vector with the coefficients of the fundamental elements and $A$ is a matrix containing the linear relationship between the fundamental elements and the field measurements.

11. The method according to claim 8, **characterised in that** two reference surfaces (15) are defined in step a) when the properties measured in step b) are the intensity of the signal captured by the probe antenna (1).

12. The method according to claim 11, **characterised in that**, when the properties measured in step b) is the intensity of the signal captured by the probe antenna (1), the representation of the electromagnetic field generated from the basis function expansion of step d) comprises the following sub-steps:

d.i) assigning an arbitrary initial phase $\varphi_1$ to the data measured in the first reference surface (15);

d.ii) calculating the weights of basis functions as coefficients that minimise the cost function

$$CF_1(x) = \|A_1 x - b_1\|_2$$

where $CF_1$ is the cost function, $b_1$ is a column vector with the field measurements in the first surface with the measured intensity and with phase $\varphi_1$, x is a vector with the weights of the basis functions and $A_1$ is a matrix containing the linear relationship between the basis functions and the field measurements in the first of the surfaces;

d.iii) calculating the field in the second reference surface (15) from the basis function expansion calculated in step d.ii) obtaining a phase vector $\varphi_2$ corresponding to the field in the measured positions of the second reference surface (15);

d.iv) calculating the coefficients of the basis functions, which will be those that minimise the cost function

$$CF_2(x) = \|A_2 x - b_2\|_2$$

where $CF_2$ is the cost function, $b_2$ is a column vector with the field measurements in the second surface with the amplitude measured and with the phase calculated in step d.iii), $\varphi_2$, x is a vector with the weights of the basis functions and $A_2$ is a matrix containing the linear relationship between the basis functions and the field measurements in the first of the surfaces;

d.v) calculating the field in the first reference surface (15) from the basis function expansion calculated in step d.iv) obtaining a phase vector $\varphi_1$, corresponding to the field in the measured positions of the first reference surface (15);

d.vi) repeating steps d.ii) to d.v) if at least one convergence criterion is not achieved.

13. The method according to claim 9, **characterised in that** the homogenisation of step c) comprises discretising the investigation volume from the orthogonal projection at a distance h from cells comprised in the reference surface (15), thus configuring a plurality of non-overlapping discrete volumes (16), wherein the number of captures of the radiated signal (2) does not exceed a certain threshold.

14. The method according to claim 8, **characterised in that** after step e) it further comprises step

f) calculating the radiation pattern of the antenna being measured (3) from the basis function expansion obtained in step d).

15. The method according to claim 8, wherein the basis functions of step d) model equivalent currents in the aperture of the antenna being measured (3).

**Patentansprüche**

1. System zum Prüfen von Antennen, umfassend:

   - mindestens eine Sondenantenne (1), die das Strahlungssignal (2) erfasst, das von der zu messenden Antenne (3) abgestrahlt wird, wenn sie sich entlang eines Pfads (7) bewegt,
   - eine Radiofrequenzeinheit (4), die eine oder mehrere Eigenschaften des Signals misst, das von der Sondenantenne (1) entlang eines Pfads (7) erfasst wird,
   - Positionierungsmittel (5), welche die Position der Sondenantenne (1) entlang des Pfads (7) bereitstellen,
   - Verarbeitungsmittel (6) mit mindestens einem Prozessor, einem Speicher und einem oder mehreren Programmen, die im Speicher gespeichert sind und eine Vielzahl von Anweisungen umfassen, welche die Prüfung der zu messenden Antenne (3) ausführen, indem sie die Eigenschaften des Signals, das von der Radiofrequenzeinheit (4) gemessen wird, in Kombination mit der Position, die von den Positionierungsmitteln (5) bereitgestellt wird, verarbeiten,

   **dadurch gekennzeichnet, dass** die Sondenantenne (1) von einem Bediener manuell auf einem beliebigen Pfad (7) innerhalb eines Untersuchungsvolumens bewegt werden kann, das eine Referenzoberfläche (15) umfasst, die sich in einem Abstand zwischen 1 cm und 100 cm von der zu messenden Antenne (3) befindet, und dass die Verarbeitungsmittel (6) eine Vielzahl von Anweisungen umfassen, welche, wenn sie von dem Prozessor ausgeführt werden, die zu messende Antenne (3) durch die Berechnung von mindestens der tangentialen Komponente des elektrischen Felds oder des magnetischen Felds oder von beiden in der Öffnung der zu messenden Antenne (3) prüfen, basierend auf einer Repräsentation mittels einer Basisfunktionserweiterung von äquivalenten Strömen in der Öffnung oder elektrischen Feldmodi, die aus den Eigenschaften des Signals, das von der Sondenantenne (1), die mit der Position verknüpft ist, die von den Positionierungsmitteln (5) bereitgestellt wird, erfasst wird, erhalten werden.

2. System nach Anspruch 1, **dadurch gekennzeichnet, dass** die Radiofrequenzeinheit (4) die Intensität des Signals, das von der Sondenantenne (1) erfasst wird, oder sowohl die Phase als auch die Intensität des Signals, das von der Sondenantenne (1) erfasst wird, misst.

3. System nach Anspruch 2, **dadurch gekennzeichnet, dass** die Radiofrequenzeinheit (4), wenn die Radiofrequenzeinheit (4) sowohl die Phase als auch die Intensität des Signals, das von der Sondenantenne (1) erfasst wird, misst, einen tragbaren Vektornetzwerkanalysator (13) umfasst.

4. System nach Anspruch 2, **dadurch gekennzeichnet, dass** die Radiofrequenzeinheit (4), wenn sie die Intensität des Signals, das von der Sondenantenne (1) erfasst wird, misst, einen Leistungsdetektor (14) oder einen Spektrumanalysator umfasst.

5. System nach Anspruch 1, **dadurch gekennzeichnet, dass** die Sondenantenne (1) in die Radiofrequenzeinheit (4) integriert ist.

6. System nach Anspruch 5, **dadurch gekennzeichnet, dass** die Positionierungsmittel (5) und die Verarbeitungsmittel (6) zusammen mit der Sondenantenne (1) und der Radiofrequenzeinheit (4) in ein und demselben Gerät integriert sind, wobei das Gerät vorzugsweise ein Mobiltelefon (19) ist.

7. System nach Anspruch 1, **dadurch gekennzeichnet, dass** die Verarbeitungsmittel (6) eine Vielzahl von Anweisungen umfassen, welche bewirken, wenn sie vom Prozessor ausgeführt werden, dass die Verarbeitungsmittel (6) so konfiguriert werden, dass sie das Verfahren nach einem der Ansprüche 8 bis 15 ausführen.

8. Verfahren zum Prüfen von Antennen mittels des Systems nach Anspruch 1, umfassend die folgenden Schritte:

a) Definieren von mindestens einer Referenzoberfläche (15) basierend auf den Eigenschaften des Strahlungssignals (2), das von einer zu messenden Antenne (3) abgestrahlt wird, wobei sich die Referenzoberfläche (15) in einem Abstand zwischen 1 cm und 100 cm von der zu messenden Antenne (3) befindet,
b) manuelles Bewegen einer Sondenantenne (1), die einen beliebigen Pfad (7) innerhalb eines Untersuchungsvolumens, welches die Referenzoberfläche (15) umfasst, beschreibt, Erfassen des Strahlungssignals (2), das von der zu messenden Antenne (3) abgestrahlt wird, und Messen seiner Eigenschaften mittels einer Radiofrequenzeinheit (4) und Bestimmen der Position der Sondenantenne (1) entlang des Pfads (7),
c) Homogenisieren der räumlichen Abtastung von Messungen des Strahlungssignals (2), das von der zu messenden Antenne (3) abgestrahlt wird,
d) Verarbeiten der erfassten Informationen, um eine Repräsentation des elektromagnetischen Felds, welches von der zu messenden Antenne (3) erzeugten wird, als Basisfunktionserweiterung zu erhalten,
e) Prüfen der zu messenden Antenne (3) mittels der Berechnung von mindestens der tangentialen Komponente des elektrischen Felds oder des magnetischen Felds oder von beiden in der Öffnung der zu messenden Antenne (3),

wobei die Schritte c), d) und e) optional für einen jeden der Strahlen wiederholt werden, welche von der zu messenden Antenne (3) abgestrahlt werden.

9. Verfahren nach Anspruch 8, **dadurch gekennzeichnet, dass** die Eigenschaften, die in Schritt b) gemessen werden, sowohl die Phase als auch die Intensität des Signals, das von der Sondenantenne (1) erfasst wird, oder die Intensität des Signals, das von der Sondenantenne (1) erfasst wird, sind.

10. Verfahren nach Anspruch 9, **dadurch gekennzeichnet, dass**, wenn die in Schritt b) gemessenen Eigenschaften sowohl die Phase als auch die Intensität des Signals sind, welches von der Sondenantenne (1) erfasst wird, die Koeffizienten der Basisfunktionserweiterung des elektromagnetischen Felds von Schritt d) durch Ermitteln der Koeffizienten erhalten werden, welche die Kostenfunktion

$$CF(x) = \|Ax - b\|_2$$

minimieren, wobei $CF$ die Kostenfunktion ist, $b$ ein Spaltenvektor mit den Feldmessungen ist, $X$ ein Vektor mit den Koeffizienten der Grundelemente ist und $A$ eine Matrix ist, welche die lineare Beziehung zwischen den Grundelementen und den Feldmessungen enthält.

11. Verfahren nach Anspruch 8, **dadurch gekennzeichnet, dass** in Schritt a) zwei Referenzflächen (15) definiert werden, wenn die in Schritt b) gemessenen Eigenschaften die Intensität des Signals, das von der Sondenantenne (1) erfasst wird, sind.

12. Verfahren nach Anspruch 11, **dadurch gekennzeichnet, dass**, wenn die in Schritt b) gemessenen Eigenschaften die Intensität des Signals sind, das von der Sondenantenne (1) erfasst wird, die Repräsentation des elektromagnetischen Felds, welche aus der Basisfunktionserweiterung von Schritt d) erzeugt wird, die folgenden Unterschritte umfasst:

d.i) Zuweisen einer beliebigen Anfangsphase $\varphi_1$ zu den Daten, die in der ersten Referenzoberfläche (15) gemessen werden,
d.ii) Berechnen der Gewichte der Basisfunktionen als Koeffizienten, welche die Kostenfunktion

$$CF_1(x) = \|A_1x - b_1\|_2$$

minimieren,

wobei $CF_1$ die Kostenfunktion ist, $b_1$ ein Spaltenvektor mit den Feldmessungen in der ersten Oberfläche mit der gemessenen Intensität und mit der Phase $\varphi_1$ ist, $X$ ein Vektor mit den Gewichten der Basisfunktionen ist und $A_1$ eine Matrix ist, welche die lineare Beziehung zwischen den Basisfunktionen und den Feldmessungen in der ersten der Oberflächen enthält,

d.iii) Berechnen des Felds in der zweiten Referenzoberfläche (15) aus der Basisfunktionserweiterung, die in Schritt d.ii) berechnet wird, Erhalten eines Phasenvektors $\varphi_2$, der dem Feld in den gemessenen Positionen der zweiten Referenzoberfläche (15) entspricht,

d.iv) Berechnen der Koeffizienten der Basisfunktionen, die jene sind, welche die Kostenfunktion

$$CF_2(x) = \|A_2 x - b_2\|_2$$

minimieren,

wobei $CF_2$ die Kostenfunktion ist, $b_2$ ein Spaltenvektor mit den Feldmessungen in der zweiten Oberfläche mit der gemessenen Amplitude und mit der in Schritt d.iii) berechneten Phase $\varphi_2$ ist, $X$ ein Vektor mit den Gewichten der Basisfunktionen ist und $A_2$ eine Matrix ist, welche die lineare Beziehung zwischen den Basisfunktionen und den Feldmessungen in der ersten der Oberflächen enthält,

d.v) Berechnen des Felds in der ersten Referenzoberfläche (15) aus der Basisfunktionserweiterung, die in Schritt d.iv) berechnet wird, Erhalten eines Phasenvektors $\varphi_1$ entsprechend dem Feld in den gemessenen Positionen der ersten Referenzoberfläche (15),

d.vi) Wiederholen der Schritte d.ii) bis d.v), wenn mindestens ein Konvergenzkriterium nicht erreicht wird.

13. Verfahren nach Anspruch 9, **dadurch gekennzeichnet, dass** die Homogenisierung von Schritt c) die Diskretisierung des Untersuchungsvolumens aus der orthogonalen Projektion in einem Abstand h von Zellen umfasst, die in der Referenzoberfläche (15) enthalten sind, wodurch eine Vielzahl von nicht überlappenden diskreten Volumina (16) konfiguriert wird, wobei die Anzahl der Erfassungen des Strahlungssignals (2) einen bestimmten Schwellenwert nicht überschreitet.

14. Verfahren nach Anspruch 8, **dadurch gekennzeichnet, dass** es nach Schritt e) ferner umfasst den Schritt
f) Berechnen des Strahlungsmusters der zu messenden Antenne (3) aus der Basisfunktionserweiterung, die in Schritt d) erhalten wird.

15. Verfahren nach Anspruch 8, wobei die Basisfunktionen von Schritt d) äquivalente Ströme in der Öffnung der zu messenden Antenne (3) modellieren.


**Revendications**

1. Système de diagnostic d'antenne, comprenant :

- au moins une antenne à sonde (1) qui capte le signal rayonné (2), qui est rayonné par l'antenne mesurée (3) lorsqu'elle se déplace le long d'une trajectoire (7) ;
- une unité de radiofréquence (4) qui mesure une ou plusieurs des propriétés du signal capté par l'antenne à sonde (1) le long d'une trajectoire (7) ;
- des moyens de positionnement (5) fournissant la position de l'antenne à sonde (1) le long de la trajectoire (7) ;
- des moyens de traitement (6) ayant au moins un processeur, une mémoire et un ou des programmes qui sont stockés dans la mémoire et comprennent une pluralité d'instructions réalisant le diagnostic de l'antenne mesurée (3) en traitant les propriétés du signal mesuré par l'unité de radiofréquence (4) combinées avec la position fournie par les moyens de positionnement (5) ;

**caractérisé en ce que** l'antenne à sonde (1) peut être déplacée manuellement par un opérateur suivant une trajectoire (7) arbitraire à l'intérieur d'un volume de recherche comprenant une surface de référence (15) qui est située à une distance comprise entre 1 cm et 100 cm de l'antenne mesurée (3), et **en ce que** les moyens de traitement (6) comprennent une pluralité d'instructions qui, lorsqu'elles sont exécutées par le processeur, effectuent un diagnostic de l'antenne mesurée (3) en calculant au moins la composante tangentielle du champ électrique, ou du champ magnétique, ou des deux, dans l'ouverture de l'antenne mesurée (3) sur la base d'une représentation au moyen d'une expansion de fonction de base de courants équivalents dans l'ouverture ou de modes de champ électrique obtenus à partir des propriétés du signal capté par l'antenne à sonde (1) associé à la position fournie par les moyens de positionnement (5).

2. Système selon la revendication 1, **caractérisé en ce que** l'unité de radiofréquence (4) mesure l'intensité du signal capté par l'antenne à sonde (1) ou à la fois la phase et l'intensité du signal capté par l'antenne à sonde (1).

3. Système selon la revendication 2, **caractérisé en ce que**, lorsque l'unité de radiofréquence (4) mesure à la fois la phase et l'intensité du signal capté par l'antenne à sonde (1), l'unité de radiofréquence (4) comprend un analyseur de réseau vectoriel portatif (13).

4. Système selon la revendication 2, **caractérisé en ce que**, lorsque l'unité de radiofréquence (4) mesure l'intensité du signal capté par l'antenne à sonde (1), l'unité de radiofréquence (4) comprend un détecteur de puissance (14) ou un analyseur de spectre.

5. Système selon la revendication 1, **caractérisé en ce que** l'antenne à sonde (1) est intégrée dans l'unité de radiofréquence (4).

6. Système selon la revendication 5, **caractérisé en ce que** les moyens de positionnement (5) et les moyens de traitement (6) sont intégrés dans un seul et même dispositif avec l'antenne à sonde (1) et l'unité de radiofréquence (4), dans lequel le dispositif est de préférence un téléphone mobile (19).

7. Système selon la revendication 1, **caractérisé en ce que** les moyens de traitement (6) comprennent une pluralité d'instructions qui, lorsqu'elles sont exécutées par le processeur, font en sorte que les moyens de traitement (6) soient configurés pour exécuter la méthode selon l'une des revendications 8 à 15.

8. Méthode de diagnostic d'antenne au moyen du système de la revendication 1, comprenant les étapes suivantes :

a) définir au moins une surface de référence (15) sur la base des propriétés du signal rayonné (2), qui est rayonné par une antenne mesurée (3), dans laquelle la surface de référence (15) est située à une distance comprise entre 1 cm et 100 cm de l'antenne mesurée (3) ;
b) déplacer manuellement une antenne à sonde (1) décrivant une trajectoire (7) arbitraire à l'intérieur d'un volume de recherche comprenant la surface de référence (15), capter le signal rayonné (2) rayonné par l'antenne mesurée (3) et mesurer ses propriétés au moyen d'une unité de radiofréquence (4), et déterminer la position de l'antenne à sonde (1) le long de la trajectoire (7) ;
c) homogénéiser l'échantillonnage spatial des mesures du signal rayonné (2) rayonné par l'antenne mesurée (3) ;
d) traiter les informations acquises pour obtenir une représentation du champ électromagnétique généré par l'antenne mesurée (3) sous la forme d'une expansion de fonction de base ;
e) effectuer un diagnostic de l'antenne mesurée (3) en calculant au moins la composante tangentielle du champ électrique, ou du champ magnétique, ou des deux, dans l'ouverture de l'antenne mesurée (3) ;

dans laquelle les étapes c), d) et e) sont facultativement répétées pour chacun des faisceaux rayonnés par l'antenne mesurée (3).

9. Méthode selon la revendication 8, **caractérisée en ce que** les propriétés mesurées à l'étape b) sont à la fois la phase et l'intensité du signal capté par l'antenne à sonde (1), ou l'intensité du signal capté par l'antenne à sonde (1).

10. Méthode selon la revendication 9, **caractérisée en ce que**, lorsque les propriétés mesurées à l'étape b) sont à la fois la phase et l'intensité du signal capté par l'antenne à sonde (1), les coefficients de l'expansion de fonction de base du champ électromagnétique de l'étape d) sont obtenus en trouvant les coefficients qui minimisent la fonction de coût

$$CF(x) = \|Ax - b\|_2$$

où CF est la fonction de coût, b est un vecteur colonne contenant les mesures de champ, x est un vecteur contenant les coefficients des éléments fondamentaux et A est une matrice contenant la relation linéaire entre les éléments fondamentaux et les mesures de champ.

**11.** Méthode selon la revendication 8, **caractérisée en ce que** deux surfaces de référence (15) sont définies à l'étape a) lorsque les propriétés mesurées à l'étape b) sont l'intensité du signal capté par l'antenne à sonde (1).

**12.** Méthode selon la revendication 11, **caractérisée en ce que**, lorsque les propriétés mesurées à l'étape b) sont l'intensité du signal capté par l'antenne à sonde (1), la représentation du champ électromagnétique généré à partir de l'expansion de fonction de base de l'étape d) comprend les sous-étapes suivantes :

d.i) attribuer une phase $\varphi 1$ initiale arbitraire aux données mesurées dans la première surface de référence (15) ;
d.ii) calculer les poids des fonctions de base en tant que coefficients qui minimisent la fonction de coût

$$CF_1(x) = \|A_1 x - b_1\|_2$$

où $CF_1$ est la fonction de coût, $b_1$ est un vecteur colonne contenant les mesures de champ dans la première surface avec l'intensité mesurée et avec la phase $\varphi_1$, x est un vecteur contenant les poids des fonctions de base et $A_1$ est une matrice contenant la relation linéaire entre les fonctions de base et les mesures de champ dans la première des surfaces ;
d.iii) calculer le champ dans la deuxième surface de référence (15) à partir de l'expansion de fonction de base calculée à l'étape d.ii), obtenant un vecteur de phase $\varphi_2$ correspondant au champ dans les positions mesurées de la deuxième surface de référence (15) ;
d.iv) calculer les coefficients des fonctions de base, qui seront ceux qui minimisent la fonction de coût

$$CF_2(x) = \|A_2 x - b_2\|_2$$

où $CF_2$ est la fonction de coût, $b_2$ est un vecteur colonne contenant les mesures de champ dans la deuxième surface avec l'amplitude mesurée et avec la phase $\varphi_2$ calculée à l'étape d.iii), x est un vecteur contenant les poids des fonctions de base et $A_2$ est une matrice contenant la relation linéaire entre les fonctions de base et les mesures de champ dans la première des surfaces ;
d.v) calculer le champ dans la première surface de référence (15) à partir de l'expansion de fonction de base calculée à l'étape d.iv), obtenant un vecteur de phase $\varphi_1$ correspondant au champ dans les positions mesurées de la première surface de référence (15) ;
d.vi) répéter les étapes d.ii) à d.v) si au moins un critère de convergence n'est pas atteint.

**13.** Méthode selon la revendication 9, **caractérisée en ce que** l'homogénéisation de l'étape c) comprend la discrétisation du volume de recherche à partir de la projection orthogonale à une distance h des cellules comprise dans la surface de référence (15), configurant ainsi une pluralité de volumes discrets non chevauchants (16), dans laquelle le nombre de captures du signal rayonné (2) ne dépasse pas un certain seuil.

**14.** Méthode selon la revendication 8, **caractérisée en ce qu'**après l'étape e) elle comprend en outre l'étape f) de calcul du diagramme de rayonnement de l'antenne mesurée (3) à partir de l'expansion de fonction de base obtenue à l'étape d).

**15.** Méthode selon la revendication 8, dans laquelle les fonctions de base de l'étape d) modélisent des courants équivalents dans l'ouverture de l'antenne mesurée (3).

FIG. 1

**FIG. 2**

FIG. 3

FIG. 4

```
                    ┌─────────────────────┐
                    │   Initialisation    │
                    └─────────────────────┘
┌ ─ ─ ─ ─ ─ ─ ─ ─ ─ ─ ─ ─ ─ ─ ─ ─ ─ ─ ─ ─ ─ ─ ─ ─ ─ ┐
│   Movement of        ┌──────────────┐  ┌────────────────────┐ │
│  probe antenna relative  │     ABM      │  │ Calculation of probe │ │
│   to the ABM according   │ signal acquisition │ │  antenna position   │ │
│  to the reference surface └──────────────┘  └────────────────────┘ │
└ ─ ─ ─ ─ ─ ─ ─ ─ ─ ─ ─ ─ ─ ─ ─ ─ ─ ─ ─ ─ ─ ─ ─ ─ ─ ┘
                    ┌─────────────────────┐
                    │   Homogenisation    │
                    └─────────────────────┘
          ┌───────────────────────────────────┐
          │  Representation of the ABM field   │
          │   as a basis function expansion    │
          └───────────────────────────────────┘
          ┌ ─ ─ ─ ─ ─ ─ ─ ─ ─ ─ ─ ─ ─ ─ ─ ─ ─ ┐
            Calculation of the ABM far field
          │  from the basis function expansion  │
          └ ─ ─ ─ ─ ─ ─ ─ ─ ─ ─ ─ ─ ─ ─ ─ ─ ─ ┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- ES 2639687 B2
- US 20180368011 A1
- US 20180351631 A1
- US 20180090837 A1
- US 9439092 B1

**Non-patent literature cited in the description**

- **GORDON, J. A. ; NOVOTNY, D. R. ; FRANCIS, M. H. ; WITTMANN, R. C. ; BUTLER, M. L. ; CURTIN, A. E. ; GUERRIERI, J. R.** Millimeter-Wave Near-Field Measurements Using Coordinated Robotics. *IEEE Transactions on Antennas and Propagation,* December 2015, 5351-5362
- **A. GEISE ; O. NEITZ ; J. MIGL ; H.-J. STEINER ; T. FRITZEL ; C. HUNSCHER ; T. F. EIBERT.** A Crane Based Portable Antenna Measurement System - System Description and Validation. *IEEE Transactions on Antennas and Propagation,* 2019, 1-12
- **H. HE ; P. MAHESHWARI ; D. J. POMMERENKE.** The development of an EM-field probing system for manual near-field scanning. *IEEE Transactions on Electromagnetic Compatibility,* April 2016, vol. 58, 356-363